(19) Europäisches Patentamt
European Patent Office
Office européen des brevets

(11) **EP 0 926 927 A1**

(12) **EUROPEAN PATENT APPLICATION**

(43) Date of publication:
**30.06.1999 Bulletin 1999/26**

(51) Int. Cl.⁶: **H05B 33/10**, C23C 14/12, C23C 14/24

(21) Application number: **98310594.1**

(22) Date of filing: **22.12.1998**

(84) Designated Contracting States:
**AT BE CH CY DE DK ES FI FR GB GR IE IT LI LU MC NL PT SE**
Designated Extension States:
**AL LT LV MK RO SI**

(30) Priority: **27.12.1997 JP 36802997**

(71) Applicant: **TDK Corporation**
**Chuo-ku, Tokyo (JP)**

(72) Inventors:
• **Tanabe, Hiroshi**
**Tokyo (JP)**

• **Nakaya, Kenji**
**Tokyo (JP)**
• **Ohisa, Kazutoshi**
**Tokyo (JP)**
• **Ara, Kensuke**
**Tokyo (JP)**
• **Arai, Michio**
**Tokyo (JP)**

(74) Representative:
**Wise, Stephen James et al**
**c/o RAWORTH, MOSS & COOK,**
**Raworth House,**
**36 Sydenham Road**
**Croydon, Surrey CR0 2EF (GB)**

(54) **Apparatus and method for preparing organic EL devices**

(57)    An apparatus for preparing organic EL devices includes a substrate (2) and an evaporation source (4). The source is disposed relative to the substrate such that the angle (θ) included between the substrate surface and a line (A) connecting the center of an opening of the evaporation source and the center of the substrate is 20-60°. The invention is effective for restraining the occurrence of current leakage and complies with substrates of a relatively large area. Organic EL devices can be efficiently produced on a mass scale.

FIG. 1

## Description

This invention relates to an apparatus and method for preparing organic electroluminescent (EL) devices. More particularly, it relates to an apparatus and method for preparing organic EL devices by heating an organic source material for evaporation and depositing the material on a substrate to form a thin film.

BACKGROUND OF THE INVENTION

Vacuum evaporation is a traditional thin film forming technique. The vacuum evaporation technique generally uses an evaporation source and a substrate on which a film is to be formed which are properly positioned in a vacuum chamber whereupon a thin film is formed on the substrate. A variety of means were devised for constructing the evaporation source. For example, a so-called resistance heating evaporation process is known in the art. It is a process of conducting electric current across a metal container or boat having a relatively high electric resistance to generate heat with which a source material in the container is evaporated, as described in Appl. Phys. Lett., 68 (16), 15 April 1996. Also known in the art are so-called electron beam/laser beam evaporation processes of directly irradiating electron or laser beams to a source material for evaporating the source material with their energy. Of these, the resistance heating evaporation process is widely employed because the film forming apparatus is of simple construction and thin films of quality can be formed at low cost.

In the resistance heating evaporation process, a source material container or metal boat is manufactured by forming a metal material having a high melting point such as tungsten, tantalum or molybdenum into a thin sheet having a high electric resistivity and working the sheet into the container shape. A source material is placed in the container. Direct current is conducted across the container to generate heat, with which the source material is evaporated to supply a gas. Part of scattering gas deposits on a substrate to form a thin film thereon. The source material used for evaporation may be any of materials having a relatively high vapor pressure although those materials capable of chemical reaction with the container should be excluded.

When organic EL display devices are manufactured by such evaporation process, to reduce the fraction defective is an important task especially for mass-scale manufacture. More particularly, if an organic layer is unevenly deposited, if the organic layer is damaged when an electron injecting electrode and other functional thin films are subsequently deposited, or inversely if the electron injecting electrode is contaminated with impurities or oxidized, then defectives such as luminance variations and dot defects can be introduced as well as quality variances. In particular, the occurrence of current leakage is a crucial problem. Reverse current flow or leakage current flow can cause drops of display quality such as cross-talk and luminance variations, and further incur energy consumption not contributing to light emission, typically undesirable heat generation of the device, leading to a decline of emission efficiency.

Resistance heating means is advantageous as a means for evaporating negative electrodes and other constituent thin films of organic EL devices because the damage to the organic layer is minimized. However, the size of a substrate on which a thin film can be formed by means of a vacuum evaporation apparatus is limited to a relatively small size of about 100 x 100 mm when a uniform film thickness is a consideration. For this reason, when it is desired to manufacture organic EL device displays on a commercial mass scale, only a limited number of displays can be manufactured at a time, becoming a bar against manufacture efficiency improvement. Also, since the size of a screen which can be manufactured is limited, it is difficult to meet the demand for increasing the screen size of display.

SUMMARY OF THE INVENTION

An object of the present invention is to provide an apparatus and method for efficiently preparing organic EL devices on a mass scale while restraining the occurrence of current leakage and complying with substrates of a relatively large area.

A first aspect of the invention provides an apparatus for preparing an organic EL device, comprising a substrate having a center and a surface on which the organic EL device is to be formed, and an evaporation source defining an opening having a center and disposed such that a line connecting the center of the opening of the evaporation source and the center of the substrate forms an angle of 20° to 60° with the surface of the substrate.

A second aspect of the invention provides a method for preparing an organic EL device, comprising the steps of placing in a vacuum chamber a substrate having a center and a surface on which the organic EL device is to be formed, placing an evaporation source defining an opening having a center such that a line connecting the center of the opening of said evaporation source and the center of the substrate forms an angle of 20° to 60° with the surface of the substrate, and effecting evaporation from said evaporation source.

For the organic EL device typically including a hole injecting electrode, an electron injecting electrode, and an organic layer between the electrodes, the apparatus and method of the invention are advantageously used for forming the organic layer by evaporation.

BRIEF DESCRIPTION OF THE DRAWINGS

FIG. 1 schematically illustrates the apparatus of the invention.

FIG. 2 is a cross-sectional view of a Knudsen cell used as an evaporation source in the apparatus of the invention.

FIG. 3 schematically illustrates a film forming step in which an organic layer is formed on a hole injecting electrode with a contaminant thereon by a conventional evaporation process, as one step for the manufacture of an organic EL device.

FIG. 4 schematically illustrates a subsequent step in which an electron injecting electrode is formed on the structure of FIG. 3.

FIG. 5 schematically illustrates a film forming step in which an organic layer is formed on a hole injecting electrode with a contaminant thereon by evaporation according to the invention, as one step for the manufacture of an organic EL device.

## ADVANTAGES

In most organic EL devices, the thickness of the organic layer(s) and the electron injecting electrode combined, excluding the hole injecting electrode, is about 100 nm to about 400 nm. The fact that the devices are capable of light emission despite such an extremely small film thickness means that they exert excellent display performance, but indicates that leakage can frequently occur if dust and debris are present during formation of an organic layer.

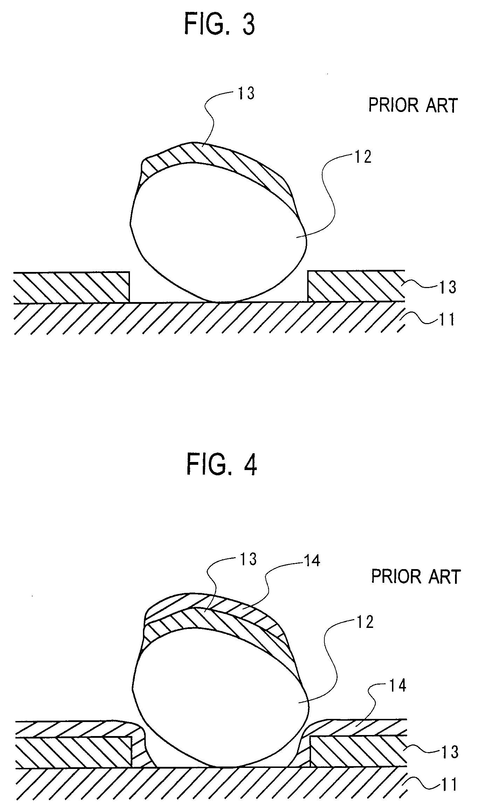

Problems associated with a conventional evaporation process are described below. Referring to FIG. 3, there is illustrated a situation where a contaminant 12 is deposited on the surface of a hole injecting electrode 11 after its formation. If an organic layer 13 is formed by a conventional evaporation process, evaporated particles characterized by straight forward movement gives rise to a shadowing phenomenon that few evaporated particles deposit in an area shadowed by the contaminant 12. Then a gap is left between the organic layer 13 and the contaminant 12 and at the shadow.

An electron injecting electrode 14 is then deposited by evaporation or sputtering. At this point, some depositing particles can laterally spread and penetrate into the shadow area whereby the electron injecting electrode 14 is extended even into the shadow area as shown in FIG. 4. As a result, in the shadow area behind the contaminant 12, the electron injecting electrode 14 is in direct contact with the hole injecting electrode 11 without interleaving the organic layer 13 therebetween, allowing for current leakage. This phenomenon becomes more outstanding when the electron injecting electrode 14 is formed by the sputtering process featuring a more lateral spread or step coverage.

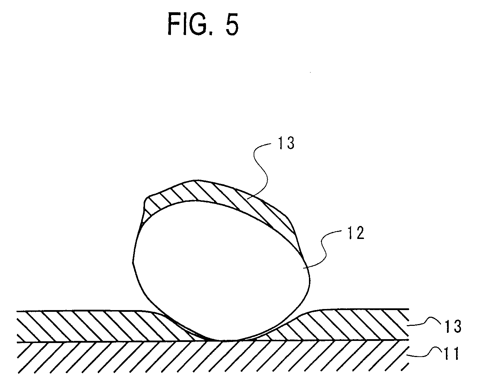

According to the invention, the evaporation source is disposed relative to the substrate such that the angle included between a line connecting the center of the opening of the evaporation source and the center of the substrate and the surface of the substrate is 20° to 60°. Then when an organic layer 13 is formed by evaporation, evaporated particles advance in an inclined direction toward the hole injecting electrode 11, resulting in improved step coverage. Then the organic layer 13 is extended even into the shadow area behind the contaminant 12 as shown in FIG. 5. When an electron injecting layer is formed thereon, the organic layer always intervenes between the electron injecting layer and the hole injecting electrode. This prevents the occurrence of current leakage.

## DESCRIPTION OF THE PREFERRED EMBODIMENTS

The apparatus for preparing an organic EL device according to the invention includes a substrate having a center and a surface on which the organic EL device is to be formed, and an evaporation source defining an opening having a center. The evaporation source is disposed relative to the substrate such that the angle between a line connecting the center of the opening of the evaporation source and the center of the substrate and the surface of the substrate is from 20° to 60°. By locating the evaporation source at a position within the specific angle range with respect to the substrate surface, the occurrence of current leakage can be avoided.

The substrate used herein is not critical as long as an organic EL device can be stacked thereon. Where emitted light exits from the substrate side, transparent or translucent materials such as glass, quartz and resins are employed. The substrate may be provided with a color filter film, a fluorescent material-containing color conversion film or a dielectric reflecting film for controlling the color of light emission. Where emitted light exits from the side opposite to the substrate, the substrate may be either transparent or opaque. Ceramics may be employed as the opaque substrates.

The size of the substrate is not critical. Preferably, the substrate has a maximum length of about 200 to about 700 mm, especially about 400 to about 700 mm, which is a diagonal length for a typical rectangular substrate. Although a maximum length of less than 200 mm is not a problem, the advantage of the invention that a uniform film thickness distribution is accomplished even on substrates of larger size becomes outstanding with a maximum length of more than 200 mm. However, a substrate size in excess of 700 mm would give rise to problems including a larger size of film forming apparatus, low deposition efficiency, and difficulty of film thickness control.

Several requirements are imposed on the evaporation source. It is required that (1) precise and steady temperature control is possible, (2) the deposition rate is high enough to accommodate mass production, (3) the container can receive a sufficient amount of source material to cover large size substrates, (4) the container is not chemically reactive with constituent materials of organic EL devices, and (5) a source material can be evaporated to a desired vapor state and diffused in a stable manner. And so, a variety of evaporation sources which can meet these requirements may be used. One typical evaporation source is a Knudsen cell. The Knudsen cell is a cell having a predetermined opening as a vapor effusion port. Provided that the opening has a diameter d and a thickness of t, the distribution of vapor density exiting from the effusion port takes the shape of a candle flame and is approximated by $\cos^n\theta$. The n value is given by the approximation that the ratio of a vapor density m at an arbitrary position to the vapor density m0 at the center, $m/m0 \propto \cos^n\theta$. As d/t decreases, the n value increases and the shape of a flame becomes acute. In case of t = 0 at the extremity, n = 1 resulting in a spherical distribution standing on the opening. This corresponds to the evaporation from an open liquid surface and is known as Langmuir evaporation. Preferably n has a value of 3 to 9.

According to the invention, the evaporation source is disposed relative to the substrate such that the angle between a line connecting the center of the opening of the evaporation source and the center of the substrate and the surface of the substrate is from 20° to 60°, preferably from 30° to 60°. By effecting evaporation from an oblique direction with respect to the substrate surface, step coverage is improved. Then an organic layer is formed so as to cover any contaminant or foreign particle on a substrate (or a hole injecting electrode or in the case of a reversely stacked structure, an electron injecting electrode), avoiding the occurrence of current leakage. If the angle between the line connecting the centers of the evaporation source opening and the substrate and the substrate surface is more than 60°, step coverage is aggravated, failing to achieve the objects of the invention. Another problem associated with an angle of more than 60° is that as the substrate size increases, the distance between the evaporation source and the substrate must be increased in order to achieve a uniform film thickness distribution, which results in a lower deposition rate. If the angle is less than 20°, the film thickness distribution becomes non-uniform and the distance between the substrate and the evaporation source must be increased along an extension line of that angle in order to achieve a uniform film thickness distribution, which undesirably requires an apparatus of greater size beyond the practically acceptable size.

Understandably, the substrate may be inclined relative to a horizontal plane. In this case, the angular relationship between the substrate and the evaporation source should be maintained the same as above. The angle of the substrate relative to the horizontal plane is usually from 0° to 60° although it is not particularly limited insofar as the angle between the substrate and the evaporation source falls within the above-defined range. As long as the above requirements are met, the substrate may be stationary or rotating. Rotation of the substrate further improves step coverage and allows a film of uniform quality and thickness distribution to deposit.

As long as the above positional relationship is met, the positions of the substrate and the evaporation source in vertical and lateral directions are not particularly limited. However, a too close distance between the substrate and the evaporation source tends to obstruct uniform evaporation over the entire surface of the substrate whereas a too long distance tends to lower the deposition rate. Then, the distance between the substrate and the evaporation source, that is, the minimum distance between the horizontal plane where the center of the opening of the evaporation source is located and the horizontal plane where the center of the substrate is located is preferably 1.5 to 3.5 times, more preferably 1.5 to 3.0 times, most preferably 1.5 to 2.5 times the distance between the center and the edge of the substrate. A plurality of evaporation sources may be arranged concentrically about the substrate center, all within the above range of substrate-to-source distance. In this case, co-evaporation may be effected.

Thin films of organic EL devices which can be formed by the apparatus of the invention include a hole injecting and transporting layer, light emitting layer, electron injecting and transporting layer, electron injecting electrode, and protective layer. To prevent current leakage as mentioned above, the step coverage during the formation of an organic layer to be disposed between the hole injecting electrode and the electron injecting electrode must be improved. Accordingly, it is preferable to form the organic layer by means of the apparatus of the invention. The evaporating material necessary for film formation is of the same composition as the organic compound contained in each layer or a combination of organic materials which gives the same composition after evaporation.

The organic layers which can be formed according to the invention are illustrated below.

The light emitting layer contains a fluorescent material that is a compound having a light emitting capability. The fluorescent material may be at least one member selected from compounds as disclosed, for example, in JP-A 264692/1988, such as quinacridone, rubrene, and styryl dyes. Also, quinoline derivatives such as metal complex dyes having 8-quinolinol or a derivative thereof as the ligand such as tris(8-quinolinolato)aluminum are included as well as tetraphenylbutadiene, anthracene, perylene, coronene, and 12-phthaloperinone derivatives. Further useful are phenylanthracene derivatives described in JP-A 12600/1996 and the tetraarylethene derivatives described in JP-A 12969/1996.

It is preferred to use the fluorescent material in combination with a host material capable of light emission by itself, that is, to use the fluorescent material as a dopant. In this embodiment, the content of the fluorescent material in the light emitting layer is preferably 0.01 to 10% by weight, especially 0.1 to 5% by weight. By using the fluorescent material in combination with the host material, the light emission wavelength of the host material can be altered, allowing light emission to be shifted to a longer wavelength and improving the luminous efficacy and stability of the device.

As the host material, quinolinolato complexes are preferable, with aluminum complexes having 8-quinolinol or a derivative thereof as the ligand being more preferable. These aluminum complexes are disclosed in JP-A 264692/1988, 255190/1991, 70733/1993, 258859/1993 and 215874/1994.

Illustrative examples include tris(8-quinolinolato)-aluminum, bis(8-quinolinolato)magnesium, bis(benzo{f}-8-quinolinolato)zinc, bis(2-methyl-8-quinolinolato)aluminum oxide, tris(8-quinolinolato)indium, tris(5-methyl-8-quinolinolato)aluminum, 8-quinolinolatolithium, tris(5-chloro-8-quinolinolato)gallium, bis(5-chloro-8-quinolinolato)calcium, 5,7-dichloro-8-quinolinolatoaluminum, tris(5,7-dibromo-8-hydroxyquinolinolato)aluminum, and poly[zinc(II)-bis(8-hydroxy-5-quinolinyl)methane].

Also useful are aluminum complexes having another ligand in addition to 8-quinolinol or a derivative thereof. Examples include bis(2-methyl-8-quinolinolato)(phenolato)aluminum(III), bis(2-methyl-8-quinolinolato)(ortho-cresolato)aluminum(III), bis(2-methyl-8-quinolinolato)(meta-cresolato)aluminum(III), bis(2-methyl-8-quinolinolato)(para-cresolato)aluminum(III), bis(2-methyl-8-quinolinolato)(ortho-phenylphenolato)aluminum(III), bis(2-methyl-8-quinolinolato)(meta-phenylphenolato)aluminum(III), bis(2-methyl-8-quinolinolato)(para-phenylphenolato)aluminum(III), bis(2-methyl-8-quinolinolato)(2,3-dimethylphenolato)aluminum(III), bis(2-methyl-8-quinolinolato)(2,6-dimethylphenolato)aluminum(III), bis(2-methyl-8-quinolinolato)(3,4-dimethylphenolato)aluminum(III), bis(2-methyl-8-quinolinolato)(3,5-dimethylphenolato)aluminum(III), bis(2-methyl-8-quinolinolato)(3,5-di-tert-butylphenolato)aluminum (III), bis(2-methyl-8-quinolinolato)(2,6-diphenylphenolato)aluminum(III), bis(2-methyl-8-quinolinolato)(2,4,6-triphenylphenolato)aluminum(III), bis(2-methyl-8-quinolinolato)(2,3,6-trimethylphenolato)aluminum(III), bis(2-methyl-8-quinolinolato)(2,3,5,6-tetramethylphenolato)aluminum(III), bis(2-methyl-8-quinolinolato)(1-naphtholato)aluminum(III), bis(2-methyl-8-quinolinolato)(2-naphtholato)aluminum(III), bis(2,4-dimethyl-8-quinolinolato)(ortho-phenylphenolato)aluminum(III), bis(2,4-dimethyl-8-quinolinolato)(para-phenylphenolato)aluminum(III), bis(2,4-dimethyl-8-quinolinolato)(meta-phenylphenolato)aluminum(III), bis(2,4-dimethyl-8-quinolinolato)(3,5-dimethylphenolato)aluminum(III), bis(2,4-dimethyl-8-quinolinolato)(3,5-di-tert-butylphenolato)aluminum(III), bis(2-methyl-4-ethyl-8-quinolinolato)(para-cresolato)aluminum(III), bis(2-methyl-4-methoxy-8-quinolinolato)(para-phenylphenolato)aluminum(III), bis(2-methyl-5-cyano-8-quinolinolato)(ortho-cresolato)aluminum(III), and bis(2-methyl-6-trifluoromethyl-8-quinolinolato)(2-naphtholato)aluminum(III).

Also acceptable are bis(2-methyl-8-quinolinolato)aluminum(III)-μ-oxo-bis(2-methyl-8-quinolinolato)aluminum (III), bis(2,4-dimethyl-8-quinolinolato)aluminum(III)-μ-oxo-bis(2,4-dimethyl-8-quinolinolato)aluminum(III), bis(4-ethyl-2-methyl-8-quinolinolato)aluminum(III)-μ-oxo-bis(4-ethyl-2-methyl-8-quinolinolato)aluminum(III), bis(2-methyl-4-methoxyquinolinolato)aluminum(III)-μ-oxo-bis(2-methyl-4-methoxyquinolinolato)aluminum(III), bis(5-cyano-2-methyl-8-quinolinolato)aluminum(III)-μ-oxo-bis(5-cyano-2-methyl-8-quinolinolato)aluminum(III), and bis(2-methyl-5-trifluoromethyl-8-quinolinolato)aluminum(III)-μ-oxo-bis(2-methyl-5-trifluoromethyl-8-quinolinolato)aluminum(III).

Other useful host materials are the phenylanthracene derivatives described in JP-A 12600/1996 and the tetraarylethene derivatives described in JP-A 12969/1996.

The light emitting layer may also serve as the electron injecting and transporting layer. In this case, tris(8-quinolinolato)aluminum etc. are preferably used.

The electron injecting and transporting compound is preferably selected from quinoline derivatives and metal complexes having 8-quinolinol or a derivative thereof as a ligand, especially tris(8-quinolinolato)aluminum (Alq3). The aforementioned phenylanthracene derivatives and tetraarylethene derivatives are also preferable.

The compound for the hole injecting and transporting layer is preferably selected from amine derivatives having strong fluorescence, for example, triphenyldiamine derivatives, styrylamine derivatives and amine derivatives having an aromatic fused ring.

The electron injecting electrode is preferably formed from materials having a low work function, for example, metal elements such as K, Li, Na, Mg, La, Ce, Ca, Sr, Ba, Al, Ag, In, Sn, Zn, and Zr, and binary or ternary alloys made of two or three such metal elements for stability improvement. Exemplary alloys are Ag-Mg (Ag: 1 to 20 at%), Al-Li (Li: 0.3 to 14 at%), In-Mg (Mg: 50 to 80 at%), and Al-Ca (Ca: 5 to 20 at%). It is understood that the electron injecting electrode can also be formed by evaporation or sputtering.

The electron injecting electrode thin film may have a sufficient thickness for electron injection, for example, a thickness of at least 0.1 nm, preferably at least 1 nm. Although the upper limit is not critical, the electrode thickness is typically about 1 to about 500 nm. On the electron injecting electrode, a protective electrode may be provided, if desired.

The protective layer may be formed using metal materials, inorganic materials such as SiOx, and organic materials such as Teflon.

During evaporation, an appropriate pressure is $1 \times 10^{-8}$ to $1 \times 10^{-5}$ Torr and the heating temperature of the evaporation source is about 100°C to about 1,400°C for metal materials and about 100°C to about 500°C for organic materials.

The organic EL light-emitting device manufactured by the method of the invention has a hole injecting electrode on a substrate and an electron injecting electrode thereon. At least a hole transporting layer, a light emitting layer and an electron transporting layer are disposed between the electrodes. The device further has a protective electrode as the uppermost layer. Of these layers, the hole transporting layer, electron transporting layer, and protective electrode are omitted as the case may be.

A transparent or translucent electrode is preferred as the hole injecting electrode because a structure allowing emitted light to exit from the substrate side is typical. Useful materials for transparent electrodes include tin-doped indium oxide (ITO), zinc-doped indium oxide (IZO), zinc oxide (ZnO), tin oxide ($SnO_2$), and indium oxide ($In_2O_3$), with ITO and IZO being preferred. The ITO usually contains $In_2O_3$ and SnO in stoichiometry although the oxygen content may deviate somewhat therefrom.

The hole injecting electrode should have a sufficient thickness for hole injection and is preferably about 50 to about 500 nm thick, especially about 50 to 300 nm thick. Although no upper limit need be imposed on the thickness of the hole injecting electrode, too thick electrodes can peel off. A too thin electrode is undesirable in film strength, hole transporting capability, and resistivity.

The hole injecting electrode can be formed by evaporation or other techniques although sputtering is preferable.

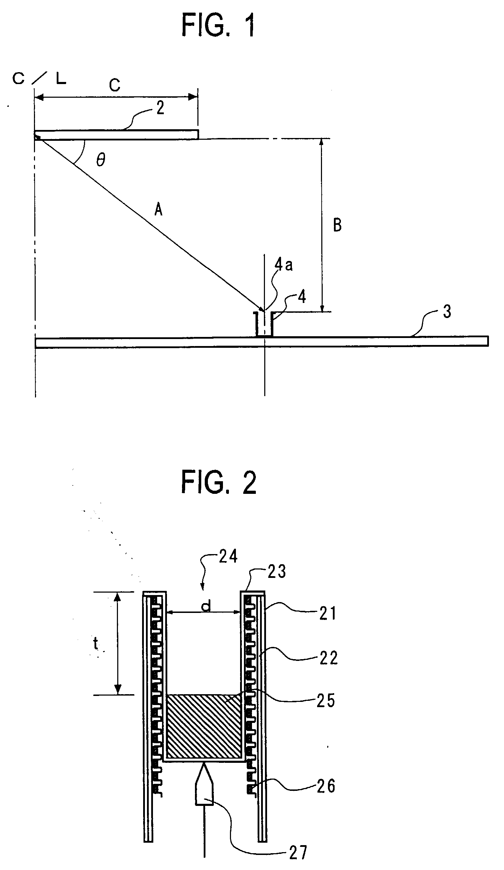

Referring to FIGS. 1 and 2, the construction of the apparatus of the invention is illustrated in more detail.

FIG. 1 is a schematic half-cut side view showing the basic construction of the apparatus for producing organic EL devices according to the invention. The apparatus includes a means for holding a substrate 2, a platform 3, and an evaporation source 4 resting on the platform 3. The substrate 2 has a center depicted by a center line C/L and a lower surface which faces the evaporation source 4 and on which an organic EL device is to be formed. The evaporation source 4 defines an opening 4a having a center. Illustrated in FIG. 1 is the right half of the apparatus with respect to the center line C/L through the substrate 2. The evaporation source 4 is disposed relative to the substrate 2 such that a line A connecting the center of the opening 4a of the evaporation source 4 and the center of the substrate 2 forms an angle θ of 20° to 60° with the substrate 2 lower surface. The height B from the opening 4a of the evaporation source 4 to the substrate 2 lower surface is about 1.5 to about 3.5 times the distance C from the center to the edge of the substrate.

FIG. 2 is a cross-sectional view showing one preferred construction of the evaporation source 4. The evaporation source 4 includes an outer casing 21, a thermal insulator 22, a crucible 23 having an opening 24 and receiving therein a material 25 to be evaporated, a heater 26 surrounding the crucible 23, and a temperature detector 27.

The crucible 23 is preferably made of a material which does not chemically react with the evaporating material 25 and withstands the predetermined temperature. Exemplary materials include ceramics such as pyrolytic boron nitride (PBN) and alumina, and quartz, with PBN being preferred. The outer casing 21 is not particularly limited as long as it has strength and corrosion resistance, and it may be selected from the same materials as the thermal insulator 22. The outer casing combined with the thermal insulator may also be used. Molybdenum is preferred for the outer casing 21. The thermal insulator 22 may be made of materials having heat reflection, heat resistance and corrosion resistance, for example, molybdenum, tantalum, stainless steel (SUS 316), Inconel, cow wool, and asbestos.

The heater 26 is not particularly limited as long as it has the desired heat capacity and reactivity. For example, tantalum wire heaters and sheath heaters are useful. The ultimate temperature by the heater 26 is preferably about 100 to about 1,400°C. An appropriate temperature control precision is about ±1°C, preferably about ±0.5°C at the temperature of 1,000°C, although it varies with a particular material to be evaporated. The temperature detector 27 should properly detect the temperature of the material 25 in the crucible 23. For example, thermocouples of platinum-platinum rhodium and tungsten-tungsten rhenium are useful.

EXAMPLE

Examples of the present invention are given below by way of illustration and not by way of limitation.

Example 1

On a glass substrate, a transparent ITO electrode (or hole injecting electrode) was deposited to a thickness of 100 nm and patterned so as to define pixels in a matrix of 64 dots x 7 lines (each pixel sized 1 x 1 mm). The substrate having the patterned hole injecting electrode was subjected to ultrasonic washing with neutral detergent, acetone, and ethanol, pulled up from boiling ethanol, and dried. The surface was further cleaned with UV/ozone.

The substrate was placed in a vacuum evaporation chamber and secured by a holder. The chamber was evacuated to a vacuum of $1 \times 10^{-4}$ Pa or lower. A Knudsen cell was used as the evaporation source. The cell was disposed relative to the substrate such that the angle (θ) between the line (A) connecting the center of the cell opening and the center of the substrate and the substrate surface was 60°, and the height (B) from the cell opening to the substrate surface was 350 mm.

The substrate was rotated, and 4,4',4''-tris(N-(3-methylphenyl)-N-phenylamino)triphenylamine (m-MTDATA) was evaporated at a deposition rate of 0.2 nm/sec. to a thickness of 40 nm, forming a hole injecting layer. With the vacuum kept, N,N'-diphenyl-N,N'-m-tolyl-4,4'-diamino-1,1'-biphenyl (TPD) was evaporated at a deposition rate of 0.2 nm/sec. to a thickness of 35 nm, forming a hole transporting layer. With the vacuum kept, tris(8-quinolinolato)aluminum (Alq3) was evaporated at a deposition rate of 0.2 nm/sec. to a thickness of 50 nm, forming an electron injecting and transporting/light emitting layer.

With the vacuum kept, the EL device substrate was transferred from the vacuum evaporation chamber to a sputtering apparatus where Mg-Ag (Ag 10 at%) was sputtered to a thickness of 200 nm, forming an electron injecting electrode.

Ten organic EL device samples were prepared in this way and examined for a percent leakage occurrence. The occurrence of current leakage was determined by measuring the luminance when all the pixels were operated and the luminance when leakage current caused light emission, with a luminance ratio of 200:1 being a criterion for judging current leakage.

As a result, each sample showed a leakage occurrence of 0.45% at maximum and 0.20% on the average. The luminance was also measured by pulse driving (duty 1/7) the device at a constant voltage of 8 volts, finding an average luminance of 102 cd/m$^2$ with a distribution within ±7%.

Example 2

Organic EL device samples were prepared as in Example 1 except that the evaporation source was disposed relative to the substrate such that the angle (θ) between the line (A) connecting the center of the cell opening and the center of the substrate and the substrate surface was 30°, and the height (B) from the cell opening to the substrate surface was 145 mm.

As a result, each sample showed a leakage occurrence of 0.22% at maximum and 0.067% on the average. The luminance was also measured by pulse driving (duty 1/7) the device at a constant voltage of 8 volts, finding an average luminance of 103 cd/m$^2$ with a distribution within ±6%.

Comparative Example 1

Organic EL device samples were prepared as in Example 1 except that the evaporation source was disposed relative to the substrate such that the angle (θ) between the line (A) connecting the center of the cell opening and the center of the substrate and the substrate surface was about 90°, and the height (B) from the cell opening to the substrate surface was 500 mm.

As a result, each sample showed a leakage occurrence of 20% at maximum and 13% on the average. The luminance was also measured by pulse driving (duty 1/7) the device at a constant voltage of 8 volts, finding an average luminance of 84 cd/m$^2$ with a distribution above ±19%. This reflects the influence of current leakage.

There has been described an apparatus and method for efficiently preparing organic EL devices on a mass scale. The invention is effective for restraining the occurrence of current leakage and complies with substrates of a relatively large area.

Japanese Patent Application No. 368029/1997 is incorporated herein by reference.

The invention has been described in detail with particular reference to preferred embodiments thereof, but it will be understood that variations and modifications can be effected within the spirit and scope of the invention.

Claims

1. An apparatus for preparing an organic electroluminescent device, comprising

a substrate having a center and a surface on which the organic electroluminescent device is to be formed, and
an evaporation source defining an opening having a center and disposed such that a line connecting the center of the opening of said evaporation source and the center of the substrate forms an angle of 20° to 60° with the surface of the substrate.

2. The apparatus of claim 1 wherein the device includes a hole injecting electrode, an electron injecting electrode, and an organic layer between the electrodes, and the apparatus is used for forming the organic layer by evaporation.

3. A method for preparing an organic electroluminescent device, comprising

placing in a vacuum chamber a substrate having a center and a surface on which the organic electroluminescent device is to be formed,
placing an evaporation source defining an opening having a center such that a line connecting the center of the opening of said evaporation source and the center of the substrate forms an angle of 20° to 60° with the surface of the substrate, and
effecting evaporation from said evaporation source.

4. The method of claim 3 wherein the device includes a hole injecting electrode, an electron injecting electrode, and an organic layer between the electrodes, and the evaporating step is to form the

organic layer.

# FIG. 1

# FIG. 2

# FIG. 3

PRIOR ART

13

12

13

11

# FIG. 4

13　14

PRIOR ART

12

14

13

11

## FIG. 5

**European Patent Office**

## EUROPEAN SEARCH REPORT

Application Number

EP 98 31 0594

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X,P | DATABASE WPI<br>Section Ch, Week 991015 December 1998<br>Derwent Publications Ltd., London, GB;<br>Class L03, AN 99-111785<br>XP002097099<br>& JP 10 335062 A (TDK), 18 December 1998<br>* abstract * | 1-4 | H05B33/10<br>C23C14/12<br>C23C14/24 |
| A,P | DATABASE WPI<br>Section Ch, Week 990915 December 1998<br>Derwent Publications Ltd., London, GB;<br>Class L03, AN 99-101505<br>XP002097100<br>& JP 10 330917 A (ULVAC), 15 December 1998<br>* abstract * | 1-4 | |

**TECHNICAL FIELDS SEARCHED (Int.Cl.6)**

H05B
C23C

The present search report has been drawn up for all claims

| Place of search | Date of completion of the search | Examiner |
|---|---|---|
| THE HAGUE | 18 March 1999 | Drouot, M-C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)